# EUROPEAN PATENT APPLICATION

(11) **EP 4 439 646 A1**
(43) Date of publication of application: **02.10.2024**
(21) Application number: 23206285.1
(22) Date of filing: 27.10.2023
(51) Int. Cl.: H01L 21/8234, H01L 27/088, H01L 29/06, H01L 29/08, H01L 29/66, H01L 29/775, H01L 29/786, H01L 29/417

(54) **BACKSIDE CONTACT ETCH BEFORE CAVITY SPACER FORMATION FOR BACKSIDE CONTACT OF TRANSISTOR SOURCE/DRAIN**

(30) Priority: 31.03.2023 US 202318129688
(71) Applicant: INTEL Corporation, Santa Clara, CA 95054 (US)
(72) Inventor: MILLS, Shaun, Hillsboro, 97123 (US); MANNEBACH, Ehren, Beaverton, 97007 (US); KOBRINSKY, Mauro, Portland, 97229 (US); CHEONG, Kai Loon, Beaverton, 97006 (US); ABD El Qader, Makram, Hillsboro, 97124 (US)
(74) Representative: Goddar, Heinz J.

(57) **Abstract**

Devices, transistor structures, systems, and techniques are described herein related to backside contacts for field effect transistors formed using a backside contact etch prior to cavity spacer formation. A transistor includes semiconductor structures such as nanoribbons extending between a source and a drain. A spacer material is between a gate and the source/drain as cavity spacer fill. The spacer material is also between a portion of a backside contact and a portion of the source/drain, to eliminate a short between the backside contact and the gate.

## Description

### BACKGROUND

Higher performance, lower cost, increased miniaturization, and greater density of integrated circuits (ICs) are ongoing goals of the electronics industry. To maintain the pace of increasing transistor density, for example, device dimensions must continue to shrink and/or new device structures are needed. In particular, gate-all-around (GAA) or nanoribbon transistors provide gate materials that surround channel regions for improved performance. Furthermore, backside power delivery or, more generally, backside contacts to transistor source and drain structures can reduce resistance and offer other advantages. However, deployment of GAA or nanoribbon transistors and backside contacts faces numerous difficulties including contact to gate shorts. It is with respect to these and other considerations that the present improvements have been needed. Such improvements may become critical as the desire to deploy advanced transistor structures becomes even more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a flow diagram illustrating methods for forming a transistor structure having a cavity or recess spacer material between a source or drain and a corresponding backside contact metal;
FIGS. 2A, 2B, 3, 4, 5, 6, 7, 8, 9 10, 11, and 12 are cross-sectional views of transistor structures evolving as the methods of FIG. 1 are practiced;
FIG. 13 illustrates exemplary systems employing transistor structures having a spacer material between a source or drain structure and a corresponding contact metal; and
FIG. 14 is a functional block diagram of an electronic computing device, all in accordance with some embodiments.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. Herein, the term "predominantly" indicates not less than 50% of a particular material or component while the term "substantially pure" indicates not less than 99% of the particular material or component and the term "pure" indicates not less than 99.9% of the particular material or component. Unless otherwise indicated, such material percentages are based on atomic percentage. Herein the term concentration is used interchangeably with material percentage and also indicates atomic percentage unless otherwise indicated.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direct contact. Furthermore, the terms "substantially," "close," "approximately," "near," and "about," generally refer to being within +/-10% of a target value. The term layer as used herein may include a single material or multiple materials. As used in throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C. The terms "lateral", "laterally adjacent" and similar terms indicate two or more components are aligned along a plane orthogonal to a vertical direction of an overall structure. As used herein, the terms "monolithic", "monolithically integrated", and similar terms indicate the components of the monolithic overall structure form an indivisible whole not reasonably capable of being separated.

Devices, transistor structures, integrated circuit dies, apparatuses, systems, and techniques are described herein related to backside contact etch before cavity spacer formation in backside contact of transistor source or drain.

As discussed, gate-all-around (GAA) or nanoribbon transistors provide gate materials that surround channel regions for improved performance. Furthermore, backside power delivery or, more generally, backside contacts to transistor source and drain structures can reduce resistance and offer other advantages in deployment of GAA field effect transistors (GAAFETs). In some embodiments, backside contact etch is performed prior to cavity spacer formation for improved device structures. For example, cavity spacers provide dielectric materials (or spacers) within cavities formed adjacent to gate structures of the GAAFETs. In some embodiments, the cavity spacers are formed adjacent to recessed sacrificial material layers such that the sacrificial material layers are later replaced by gate structures in replacement gate operations as known in the art. By performing the backside contact etch prior to cavity spacer formation, a portion of spacer material (i.e., the same material that is provided as the spacer) is in contact with the backside contact metal (later formed in the etched recess) and a portion of the source or drain (also formed after the cavity spacer). This portion of the spacer material advantageously eliminates shorts between the backside contact metal and the gate structure. The techniques discussed herein perform backside contact etch before the cavity spacer formation to eliminate contact to gate shorts. Other advantages will be evident based on the following discussion.

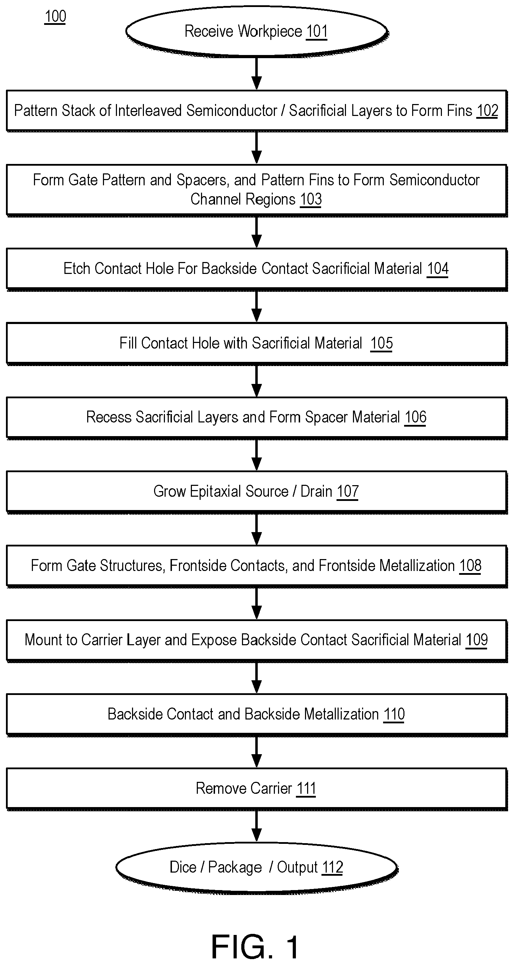

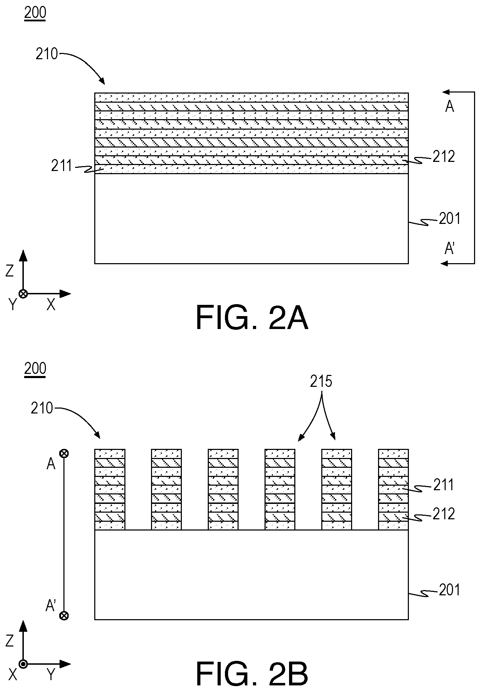

FIG. 1 is a flow diagram illustrating methods 100 for forming a transistor structure having a cavity or recess spacer material between a source or drain and a corresponding backside contact metal, arranged in accordance with at least some implementations of the present disclosure. FIGS. 2A, 2B, 3, 4, 5, 6, 7, 8, 9 10, 11, and 12 are cross-sectional views of transistor structures evolving as methods 100 are practiced, arranged in accordance with some embodiments of the disclosure. FIGS. 2A, 3, 4, 5, 6, 7, 8, 9 10, 11, and 12 provide cross-sectional views along a channel structure that extends between source to drain view while FIG. 2B provides a cross-sectional view across the gate.

Methods 100 begin at input operation 101, where a workpiece is received for processing. For example, a substrate may be received for processing such that a stack of interleaved semiconductor and sacrificial layers is formed over the substrate. The received substrate 201 may include any suitable material or materials in any format. For example, the substrate may be a monocrystalline silicon wafer or the like. The multilayer stack includes a number of semiconductor layers interleaved with sacrificial layers. For example, the semiconductor layers may be silicon (Si), germanium (Ge), silicon germanium (SiGe), III-V materials (e.g., gallium arsenide (GaAs)), or other semiconductor materials such as transition metal dichalcogenide (TMD) materials. As used herein, the term semiconductor material indicates a material with a variable conductivity that may be manipulated for use as a channel material in a transistor. The semiconductor layers are interleaved with sacrificial layers that will later be removed in replacement gate processing. The sacrificial layers may be any suitable materials having etch selectivity with respect to the semiconductor layers such as silicon oxide, aluminum oxide, molybdenum oxide, or others.

Processing continues at operation 102 where the stack of interleaved semiconductor layers and sacrificial layers (e.g., the multilayer stack) are patterned to form fins having interleaved semiconductor layers and sacrificial layers. The fins may also include subfins of portions of the substrate material.

FIG. 2A illustrates a cross-sectional side view of a transistor structure 200 including a multilayer stack 210 formed over a substrate 201. FIG. 2A provides a cross-sectional view along a channel structure (to be subsequently formed) that extends in the x-dimension. FIG. 2B illustrates another cross-sectional side view of transistor structure across a gate (to be subsequently formed) at view A-A' in FIG. 2A. As shown, transistor structure 200 includes a multilayer stack 210 of interleaved semiconductor layers 212 and sacrificial layers 211 patterned into fins 215. Substrate 201 may include any suitable material or materials. For example, substrate 201 may be a substrate substantially aligned along a predetermined crystal orientation (e.g., <100>, <111>, <110>, or the like). In some embodiments, substrate 201 is a semiconductor material such as monocrystalline silicon (Si), germanium (Ge), silicon germanium (SiGe), III-V materials (e.g., gallium arsenide (GaAs)), a silicon carbide (SiC), a sapphire (Al₂O₃), or any combination thereof. In some embodiments, substrate 201 is silicon having a <111> crystal orientation.

Multilayer stack 210 includes of a number of semiconductor layers 212 interleaved with sacrificial layers 211. Semiconductor layers 212 may be any materials discussed above such as silicon, germanium, silicon germanium, a III-V material, a TMD material, or others. Sacrificial layers 211 may be any suitable material or materials such as silicon oxide, aluminum oxide, molybdenum oxide, or others. In some embodiments, a hardmask layer (not shown) is on multilayer stack 210. For example, a pattern may be transferred to the hardmask layer using lithography techniques and the pattern may then be transferred to multilayer stack 210 to form fins 215. Semiconductor layers 212, sacrificial layers 211, and an optional hardmask layer may be formed using atomic layer deposition (ALD), chemical vapor deposition (CVD), plasma enhanced chemical vapor deposition (PECVD), metal-organic chemical vapor deposition (MOCVD), or the like. In some embodiments, fins 215 include subfin portions (i.e., extending into substrate 201 in the view of FIG. 2B) separated by isolation material.

Returning to FIG. 1, processing continues at operation 103, where a sacrificial gate structure including a patterned material and conformal spacer are formed, and the fins are patterned to form interleaved semiconductor structures and replacement gate structures. In some embodiments, a bulk material such as polysilicon is formed between and over the fins, and a gate pattern is patterned into the bulk material as lines of the bulk material orthogonal to the fins. A spacer material is then conformally deposited over the gate pattern and the resultant gate pattern and spacer are used as a mask to etch the exposed fin portions. The remaining interleaved semiconductor and sacrificial layers provide semiconductor channel structures interleaved with replacement gate structures. Other techniques may be used to form the interleaved semiconductor and sacrificial gate structures.

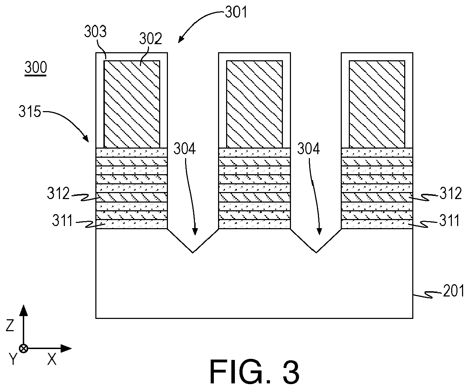

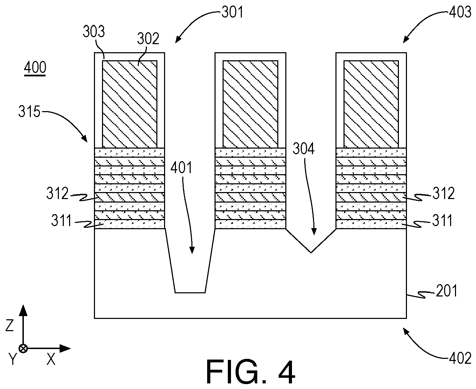

FIG. 3 illustrates a cross-sectional side view of a transistor structure 300 similar to transistor structure 200 after the formation of gate pattern 301, and using gate pattern 301 to form structures 315 each including semiconductor structures 312 and sacrificial structures 311 (e.g., replacement gate structures). FIG. 3 illustrates the cross-sectional side view of FIG. 2A, which is used as representative in FIGS. 4-12. As shown, gate pattern 301 may include a first patterned material 302 and a spacer layer 303. Fins 215 (refer to FIG. 2B) are patterned to form structures 315, which include interleaved semiconductor structures 312 and sacrificial structures 311. Structures 315 may be characterized as multilayer stacks, patterned multilayer stacks, or the like. Each multilayer stack is over substrate 201 and includes a number of interleaved semiconductor material layers (i.e., semiconductor structure 312) and sacrificial layers (i.e., sacrificial structures 311). Such semiconductor structures 312 will ultimately extend between source and drain structures with channel regions of semiconductor structures 312 being controllable by a gate structure. Semiconductor structure 312 may be characterized as nanoribbons or nanosheets depending on the format and dimensions of the resultant transistor. Such Sacrificial structures 311, after recess and cavity spacer formation, will be replaced by gate structures operable to control the channel regions of semiconductor structures 312. The material of first patterned material 302 may be any suitable material such as polysilicon or a dielectric material. The material of spacer 303 may be a dielectric material such as one or more of silicon oxide, silicon nitride, and silicon carbide. As shown, the patterning used to form structures 315 may form recesses 304 in substrate 201. In some embodiments, transistor structure 300 is received for further processing such that subsequent processing includes advantageous formation of a backside contact cavity prior to cavity spacer formation.

Returning to FIG. 1, processing continues at operation 104, where a hole or cavity is etched for the formation of a backside contact. The hole or cavity may be formed using any suitable technique or techniques. In some embodiments, a bulk material is formed between and over the fins interleaved structures formed at operation 103. The bulk material may then be patterned to expose the substrate or underlying material where the hole or cavity is to be formed. For example, the hole or cavity may be located under a source or drain region where a source or drain structure is to be formed. The source or drain structure is ultimately be contacted by a backside contact formed through the substrate. The hole or cavity is then etched using the same or subsequent etch used to pattern the bulk material.

FIG. 4 illustrates a cross-sectional side view of a transistor structure 400 similar to transistor structure 300 after the formation of a contact hole 401 adjacent one of structures 315. As discussed, contact hole 401 may be formed using any suitable technique or techniques such as bulk material deposition, planarization, and patterning to reveal a portion of substrate 201, followed by etching the exposed portion of substrate 201 to form contact hole 401. Contact hole 401 extends in the negative z-direction through substrate 201 toward a backside 402 of transistor structure 400, which is opposite a frontside 403 of transistor structure 400. As used herein the term frontside of a transistor structure indicates the side (or the direction of the side) being built up during front end of line (FEOL) processing of transistor structure 400, which is the processing performed on or over the received substrate 201, in accordance with the accepted use of frontside. The backside is then opposite the frontside and is the side opposite the buildup direction. As discussed below, contact hole 401 will be used to contact a source or drain structure from backside 402.

Returning to FIG. 1, processing continues at operation 105, where the contact hole formed at operation 104 is filled with a sacrificial material. Notably, the sacrificial material is to be removed when it is exposed from the backside as discussed further herein below. The sacrificial material may be formed in the contact hole using any suitable technique or techniques. In some embodiments, the sacrificial material is formed in the contact hole and in a hole through the bulk material patterned as discussed above. The sacrificial material may then be recessed to fill the contact hole such that a top surface of the sacrificial material substantially aligned with the top surface of the substrate and a bottom surface of a lower sacrificial structure. The bulk material may then be removed.

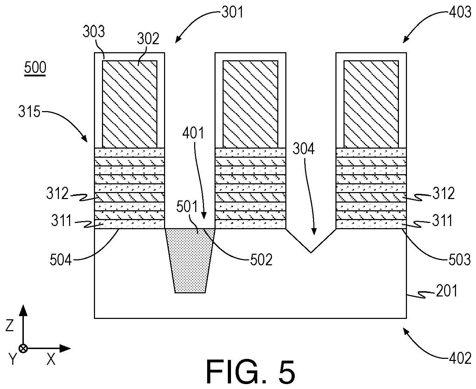

FIG. 5 illustrates a cross-sectional side view of a transistor structure 500 similar to transistor structure 400 after fill of contact hole 401 with sacrificial material 501. Sacrificial material 501 may be any suitable material having an etch selectivity relative to substrate 201. In some embodiments, sacrificial material 501 is titanium nitride (i.e., sacrificial material 501 includes titanium and nitrogen). Sacrificial material 501 may be characterized as a sacrificial contact, a sacrificial backside contact, or the like. As shown, in some embodiments sacrificial material 501 has a top surface 502 that is substantially coplanar with a top surface 503 of substrate 201 and with a bottom surface 504 of sacrificial structures 311 of structures 315.

Returning to FIG. 1, processing continues at operation 106, where cavity etch is performed to recess the sacrificial materials of the multilayer structures, cavity spacer material(s) are deposited, and the cavity spacer material(s) are etched back to provide cavity spacers in the recesses of the sacrificial materials of the multilayer structures. Such operations may be performed using any suitable technique or techniques. As discussed, the multilayer structures include remaining channel semiconductor material layers interleaved with sacrificial layers, and the multilayer structures may be characterized as multilayer channel structures as they include the channel materials of eventual GAA transistors. The cavity etch recesses the sacrificial layers, and the cavity etch may be performed using any suitable technique or techniques such as timed isotopic etch techniques selective to the sacrificial materials of the multilayer structures. The resultant cavities or recesses adjacent the sacrificial materials of the multilayer structures are then filled via cavity spacer material deposition and etch back techniques. For example, the cavity spacer material may be conformally deposited to a particular thickness and a timed etch may be performed to remove a portion of the thickness, leaving the cavity spacers. The cavity spacer electrically isolates the subsequently formed source and drain semiconductor and gate metal. As discussed herein, by performing the contact etch at operation 104 prior to cavity spacer deposition, contact to gate risk is eliminated by reducing or eliminating the consumption of the cavity spacer material during the deep contact etch. As shown, a portion of the spacer material is located between the eventual backside contact (formed by backside replacement of the sacrificial material deposited at operation 104) and the eventual source or drain (formed epitaxial to the exposed semiconductor layers of the multilayer structures).

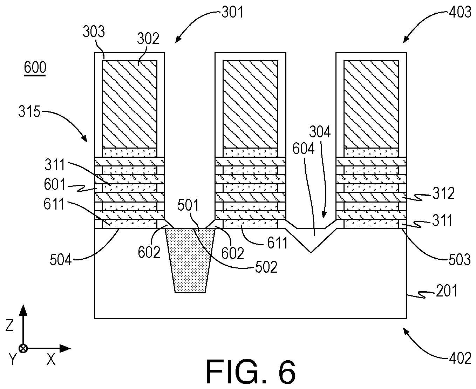

FIG. 6 illustrates a cross-sectional side view of a transistor structure 600 similar to transistor structure 500 after formation of cavity spacers 601 in recesses formed adjacent sacrificial structures 311. As discussed, cavity spacers 601 are formed by cavity etch to recess sacrificial structures 311 such that the cavity etch is selective to sacrificial structures 311 relative to semiconductor structures 312 followed by deposition of cavity spacer material and etch back. Such techniques for cavity spacers 601 and spacer material portions 602 such that cavity spacers 601 and spacer material portions 602 are the same material(s), and have the same material compositions. Furthermore, a fill spacer material 604 of the same material may be formed in any recess 304 in which a contact hole 401 is not formed. The spacer material of cavity spacers 601 and spacer material portions 602 may include any suitable material or materials. In some embodiments, the spacer material is the same or similar material to that of spacer layer 303. For example, the spacer material may be similar materials but with a different composition. For example, cavity spacers 601 may include any suitable dielectric material.

In some embodiments, the spacer material of cavity spacers 601 and spacer material portions 602 may include a low-k dielectric material. In some embodiments, the spacer material of cavity spacers 601 and spacer material portions 602 includes one or more of silicon, oxygen, carbon, and nitrogen. In some embodiments, the spacer material of cavity spacers 601 and spacer material portions 602 deploys a material including silicon and oxygen (e.g., silicon oxide). In some embodiments, the spacer material of cavity spacers 601 and spacer material portions 602 is a material including silicon and nitrogen (e.g., silicon nitride). In some embodiments, the spacer material of cavity spacers 601 and spacer material portions 602 is a material including silicon and carbon (e.g., silicon carbide). In some embodiments, the spacer material of cavity spacers 601 and spacer material portions 602 is a combination of silicon and one or more of oxygen, nitrogen, and carbon. In some embodiments, the spacer material of cavity spacers 601 and spacer material portions 602 and spacer layer 303 deploy the same material.

As shown in FIG. 6, spacer material portions 602 covers a portion of sacrificial material 501 and exposes a portion of sacrificial material 501, which will eventually be a backside contact metal. Notably, spacer material portions 602 offers a large contact region between the eventual backside contact metal and source/drain structures while eliminating a potential short to the eventual gate structure replacing lowermost sacrificial structures 611.

Returning to FIG. 1, processing continues at operation 107, where source and drain semiconductor materials are deposited (e.g., epitaxially grown). For example, the source and drain semiconductor materials suitable for the conductivity type of the GAA transistor being formed (n-type or p-type) may be deposited while other regions are masked and subsequently, source and drain semiconductor materials suitable for another conductivity type of the GAA transistor being formed (the other of n-type or p-type) using masking techniques. Epitaxial source and drain semiconductor materials are selectively formed on the exposed semiconductor materials (e.g., channel silicon). Such epitaxial growth techniques may be performed using any suitable technique or techniques. In some embodiments, vapor phase epitaxy is deployed. In some embodiments, the epitaxial growth includes molecular beam epitaxy techniques. Such epitaxial growth is selective to exposed crystal surfaces of the semiconductor material(s) and grows substantially crystalline source and drain materials that are epitaxial to (e.g., share a crystal orientation with) the semiconductor material(s).

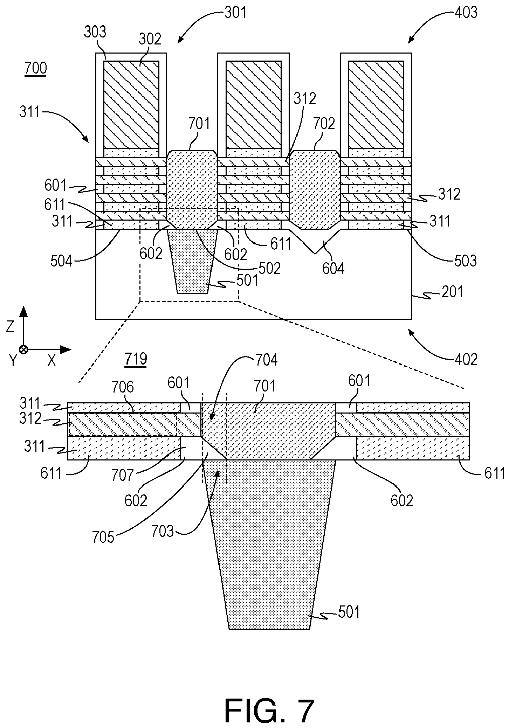

FIG. 7 illustrates a cross-sectional side view of a transistor structure 700 similar to transistor structure 600 after formation of source structure 701 and drain structure 702. Source structure 701 and drain structure 702 may be formed using any suitable technique or techniques such as vapor phase epitaxy techniques, molecular beam epitaxy techniques, or other epitaxial growth techniques. As shown, structure 701 and drain structure 702 grow epitaxially from exposed semiconductor structures 312. Source structure 701 and drain structure 702 may include faceting and growth structures and characteristics as known in the art. Source structure 701 and drain structure 702 may include any suitable material or materials for the conductivity type of GAA being formed. In some embodiments, for n-type metal oxide semiconductor (NMOS) GAA transistors, source structure 701 and drain structure 702 are epitaxial silicon doped with n-type dopants inclusive of phosphorous, arsenic, antimony, or others. For example, NMOS source and drain semiconductor materials may include silicon and one or more of phosphorous, arsenic, and antimony. In some embodiments, for n-type metal oxide semiconductor (PMOS) GAA transistors, source structure 701 and drain structure 702 are epitaxial silicon germanium doped with p-type dopants inclusive of boron, aluminum, gallium, indium, or others. For example, PMOS source and drain semiconductor materials may include silicon and germanium, and one or more of boron, aluminum, gallium, and indium. Other materials may be used.

As discussed, transistor structure 700 includes sacrificial material 501 in contact hole 401 as well as sacrificial structures 311 within structures 315. Notably, sacrificial material 501 will be accessed by backside exposure and replaced with backside contact metal while sacrificial structures 311 will be replaced with gate structures or portions of a gate structure. In the context of FIG. 7, relationships of the components of transistor structure 700 are discussed relative to sacrificial material 501 and sacrificial structures 311. It is noted such relationships will hold after replacement operations discussed herein below. Details of such relationships are illustrated in expanded view 719.

Transistor structure 700 includes semiconductor structures 312 over substrate 201 such that semiconductor structures 312 extend between source structure 701 and drain structure 702, with source structure 701 and drain structure 702 being epitaxial to semiconductor structures 312. Sacrificial structures 311 are adjacent and interleaved with channel regions 706 of semiconductor structures 312. As used herein, the term channel region indicates a region or portion of a material or structure that is manipulated by a gate to operate the transistor. Notably, the transistor need not be in operation for a region to be a channel region. The spacer material of cavity spacers 601 is between sacrificial structures 311 and source structure 701 and drain structure 702, and the spacer material of spacer material portion 602 is in contact with and between a portion of sacrificial material 501 and a portion of source structure 701. Although illustrated with respect to backside contact being made to source structure 701, backside contact may be made to source structure 701, drain structure 702, or both, with source structure 701 being typical in power delivery contexts.

As shown, the spacer material portion 602 is a continuous monolithic material portion that is in contact with lowermost sacrificial structure 611, a portion 704 of source structure 701, and a portion 703 of sacrificial material 501. As used herein, the term continuous with respect to a material indicates an unbroken whole having a same or similar composition throughout. Also as shown, a second spacer material portion 602 is also a continuous monolithic material portion that is in contact with another lowermost sacrificial structure 611, a portion of source structure 701 (unlabeled), and a portion of sacrificial material 501 (unlabeled). For example, spacer material portions 602 may be on opposite sides of sacrificial material 501 and source structure 701. Notably, spacer material portions 602 includes a region 705 that is between and in vertical alignment with portion 704 of source structure 701 and portion 703 of sacrificial material 501. Furthermore, a region 707 of spacer material portions 602 is vertically aligned with cavity spacers 601, with each of cavity spacers 601 being a continuous monolithic material portion of the same or similar spacer material.

Returning to FIG. 1, processing continues at operation 108, where gate structures are formed, frontside contacts are made, and frontside metallization layers are fabricated. Such processing may be performed using any suitable technique or techniques. In some embodiments, the sacrificial structure adjacent the semiconductor structures (e.g., channel semiconductor materials) and/or dummy gate materials are replaced with gate structures. For example, the sacrificial layers may be selectively etched, and the requisite structures may be formed via deposition and optional patterning techniques. Furthermore, source or drain structures and the gate structures may be contacted by metal contacts using any suitable technique or techniques such as patterning and metal deposition processing known in the art. Finally, frontside metallization layers may be formed over (and selectively coupled to) the frontside contacts using any suitable technique or techniques such as dual damascene techniques, single damascene techniques, subtractive metallization patterning techniques, or the like.

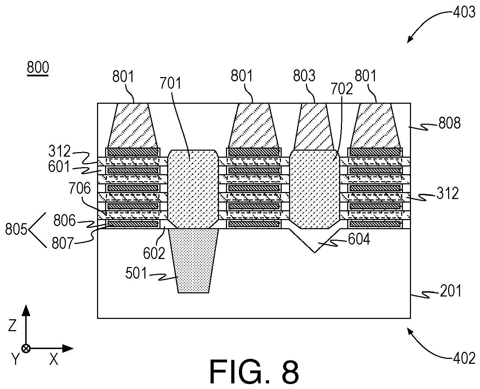

FIG. 8 illustrates a cross-sectional side view of a transistor structure 800 similar to transistor structure 700 after formation of gate structures 805, drain contact 803, gate contacts 801, and dielectric material 808. As shown, gate structures 805 include gate dielectric 806 separating gate electrodes 807 from channel regions 706 of semiconductor structures 312. Such gate electrodes 807 and gate dielectric 806 may be formed using any suitable technique or techniques such as replacement gate techniques. Furthermore, frontside gate contacts 801 and drain contact 803 may be formed using any suitable technique or techniques such as patterning, etch, and metal deposition techniques.

Such components may include any suitable materials. Gate dielectric 806 may be silicon oxide, aluminum oxide, or a high-k dielectric, such as hafnium oxide. For example, gate dielectric 806 may include elements such as hafnium, silicon, oxygen, titanium, tantalum, lanthanum, aluminum, zirconium, barium, strontium, yttrium, lead, scandium, niobium, or zinc. Gate electrodes 807 may include any suitable work function metal for gate control of GAA transistors of transistor structure 800 such as tantalum, titanium, aluminum, ruthenium, or alloys of such materials. Drain contact 803 may include any suitable conductive contact materials such as tungsten, copper, cobalt, aluminum, titanium, or the like.

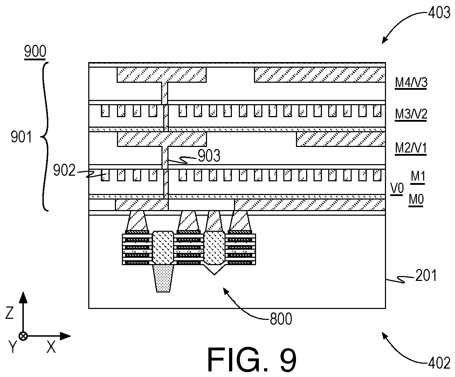

FIG. 9 illustrates a cross-sectional side view of a transistor structure 900 similar to transistor structure 800 after formation of frontside metallization layers 901 (or frontside interconnect layers). Frontside metallization layers 901 may be formed using any suitable technique or techniques such as dual damascene techniques, single damascene techniques, subtractive metallization patterning techniques, or the like. For example, interconnectivity, signal routing, power-delivery, and the like may be provided by frontside metallization layers 901. As used herein, the term metallization layer indicates metal interconnections or wires that provide electrical routing. Adjacent metallization layers, such as metallization interconnects 902, are interconnected by vias, such as vias 903, that may be characterized as part of the metallization layers or between the metallization layers. As shown, in some embodiments, frontside metallization layers 901 are formed over and immediately adjacent transistor structure 800. In the illustrated example, frontside metallization layers 901 include M0, V0, M1, M2/V1, M3/V2, and M4/V3. However, frontside metallization layers 901 may include any number of metallization layers such as six, eight, or more metallization layers.

Returning to FIG. 1, processing continues at operation 109, where the partially fabricated workpiece is mounted, by its frontside, to a carrier such as a carrier wafer, and the backside contact sacrificial material is exposed through the backside of the substrate of the workpiece. The workpiece may be mounted to the carrier using any suitable technique or techniques such as application of an adhesive film between the workpiece and carrier. The backside contact sacrificial material is the exposed using any suitable technique or techniques such as backside substrate removal processing including backside grind, backside etch or the like to thin the substrate wafer.

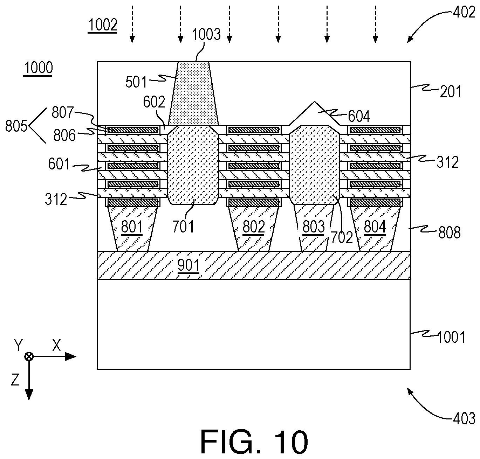

FIG. 10 illustrates a cross-sectional side view of a transistor structure 1000 similar to transistor structure 900 after attachment to carrier 1001, and backside substrate removal processing 1002 to expose a backside surface 1003 of sacrificial material 501. In FIG. 10, frontside metallization layers 901 are illustrated condensed into a single component for the sake of clarity of presentation. Furthermore, the view of FIG. 10 is inverted with respect to that of FIG. 9. For example, substrate removal processing 1002 may include backside grind (e.g., backside planarization) or backside etch processing that thins substrate 201 in a planar fashion to expose instances of sacrificial material 501 for backside contact processing. For example, sacrificial material 501 may be exposed by removal of a portion of substrate 201.

Returning to FIG. 1, processing continues at operation 110, where a contact metal is formed by replacement of the backside contact sacrificial material formed at operation 104 and after formation of backside metallization layers. Such processing may be performed using any suitable technique or techniques. In some embodiments, the backside contact sacrificial material is removed using selective etch processing and replaced with backside contact metal using deposition and planarization techniques, are replaced with gate structures. Furthermore, backside metallization layers may be formed over (and selectively coupled to) the backside contacts using any suitable technique or techniques such as dual damascene techniques, single damascene techniques, subtractive metallization patterning techniques, or the like.

Processing continues at operation 111, where the carrier is removed using any suitable technique or techniques such as delamination, UV curing, or the like, and at operation 112, where continued processing is performed as is known in the art. Such processing may include dicing, packaging, assembly, and so on. The resultant device (e.g., integrated circuit die) may then be implemented in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

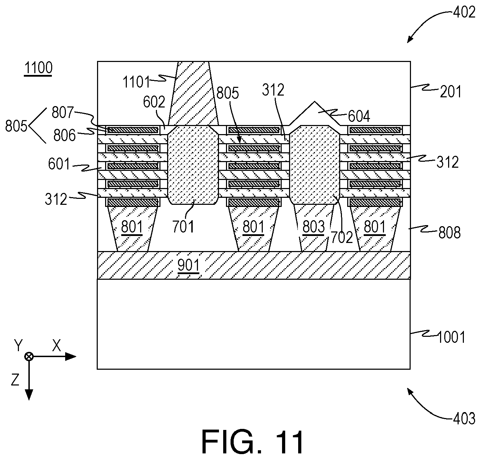

FIG. 11 illustrates a cross-sectional side view of a transistor structure 1100 similar to transistor structure 1000 after removal of sacrificial material 501 and formation of backside contact 1101 (e.g., backside contact metal). For example, sacrificial material 501 may be removed using selective etch techniques and the resultant contact hole may be filled by metal backside contact 1101 using deposition and planarization techniques. Backside contact 1101 may include, for example, a titanium cap and a tungsten fill. However, any suitable metal may be used such as tungsten, copper, cobalt, aluminum, titanium, or the like.

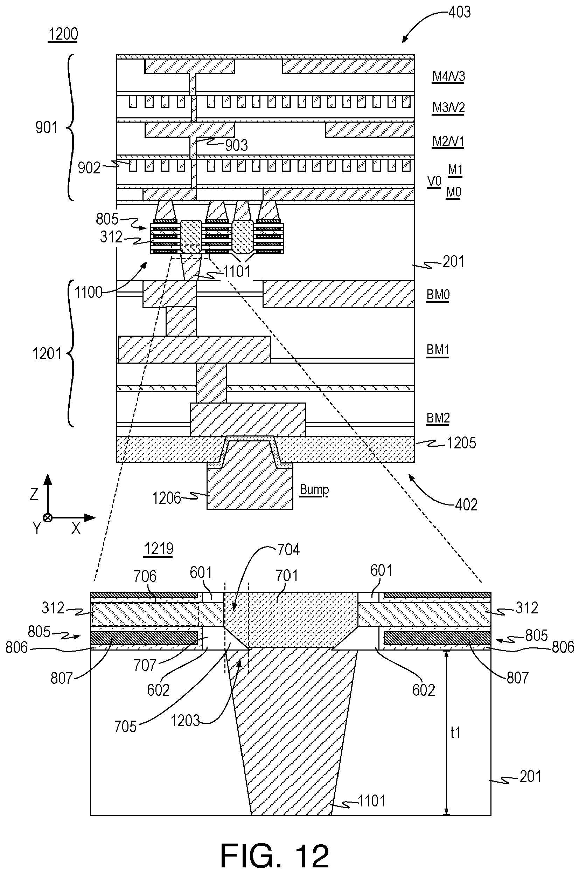

FIG. 12 illustrates a cross-sectional side view of a transistor structure 1200 similar to transistor structure 1100 after formation of backside metallization layers 1201 (or backside interconnect layers). The view of FIG. 12 is inverted with respect to that of FIG. 11, and details of transistor structure 1200 are shown in expanded view 1219. Backside metallization layers 1201 may be formed using any suitable technique or techniques such as dual damascene techniques, single damascene techniques, subtractive metallization patterning techniques, or the like. After such processing, carrier 1001 may be removed. For example, interconnectivity, signal routing, power-delivery, and routing to outside devices (not shown) may be provided by backside metallization layers 1201. In the illustrated example, package level interconnects 1206 are provided on or over backside 402 as bumps over a passivation layer 1205. However, package level interconnects 1206 may be provided using any suitable interconnect structures such as bond pads, solder bumps, etc. As shown, in some embodiments, backside metallization layers 1201 are formed over and immediately adjacent transistor structure 1100. In the illustrated example, backside metallization layers 1201 include BM0, BM1, and BM2 with intervening via layers. However, backside metallization layers 1201 are may include any number of metallization layers such as three, four, or more metallization layers.

Transistor structure 1200 includes semiconductor structures 312 (e.g., nanoribbons, nanowires, or nanosheets) over substrate 201 such that semiconductor structures 312 extend between source structure 701 and drain structure 702 (refer to FIG. 11), with source structure 701 and drain structure 702 being epitaxial to semiconductor structures 312. Gate structures 805 are adjacent and interleaved with channel regions 706 of semiconductor structures 312. As discussed, a channel region indicates a region or portion of a material or structure that is manipulated by a gate to operate the transistor, and the transistor need not be in operation for a region to be a channel region. The spacer material of cavity spacers 601 is between gate structures 805 and source structure 701 and drain structure 702 (e.g., in contact with gate dielectric 806 and source structure 701), and the spacer material of region 705 of spacer material portion 602 is in contact with and between a portion 1203 of backside contact 1101 and portion 704 of source structure 701. Backside contact 1101 extends through a thickness t1 of substrate 201.

As shown, the spacer material portion 602 is a continuous monolithic material portion that is in contact with a lowermost gate structure 805, portion 704 of source structure 701, and portion 1203 of backside contact 1101. Also as shown, a second spacer material portion 602 is also a continuous monolithic material portion that is in contact with another lowermost gate structure 805, a portion of source structure 701 (unlabeled), and a portion of backside contact 1101 (unlabeled). For example, spacer material portions 602 may be on opposite sides of backside contact 1101 and source structure 701. Notably, spacer material portions 602 includes region 705 that is between and in vertical alignment with portion 704 of source structure 701 and portion 1203 of backside contact 1101. Furthermore, region 707 of spacer material portion 602 is vertically aligned with cavity spacers 601, with each of cavity spacers 601 being a continuous monolithic material portion of the same or similar spacer material.

In some embodiments, transistor structure 1200 is deployed in a monolithic integrated circuit (IC) die including a transistor (e.g., a three-terminal transistor device), the transistor including any of the discussed components and characteristics. For example, the transistor may include stack of nanoribbons over a substrate, the stack of nanoribbons coupled to a source and a drain each epitaxial to the stack of nanoribbons, a gate structure on channel regions of the nanoribbons, a spacer material between the gate structure and each of the source and the drain, and a backside contact extending through the substrate and in contact with one of the source or the drain, such a portion of the spacer material is in contact with and between a portion of the backside contact and a portion of the source or the drain, as discussed herein. A power supply may be coupled to the IC die.

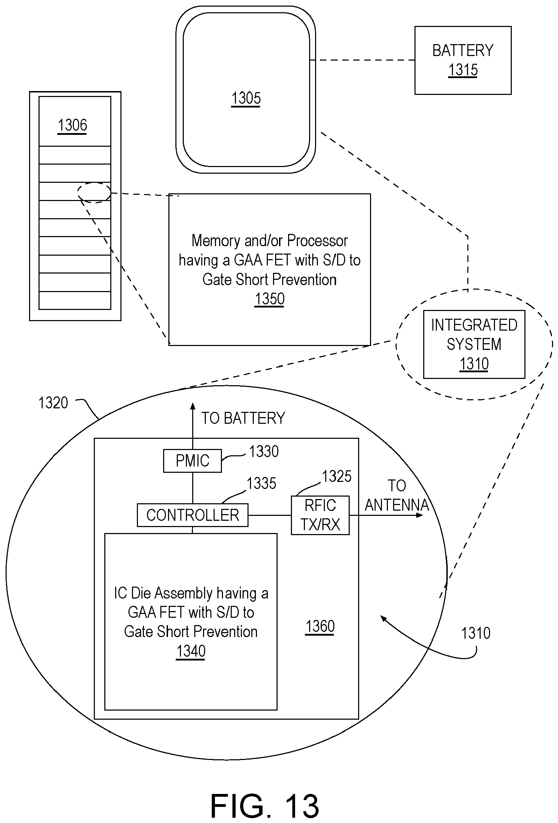

FIG. 13 illustrates exemplary systems employing transistor structures having a spacer material between a source or drain structure and a corresponding contact metal, in accordance with some embodiments. The system may be a mobile computing platform 1305 and/or a data server machine 1306, for example. Either may employ a monolithic IC die, for example, having a spacer material between a source or drain structure and a corresponding contact metal (e.g., GAA FET with S/D to Gate Short Prevention) as described elsewhere herein. Server machine 1306 may be any commercial server, for example including any number of high-performance computing platforms disposed within a rack and networked together for electronic data processing, which in the exemplary embodiment includes an IC die assembly 1350 with a field effect transistor having field effect transistor having a spacer material between a source or drain structure and a corresponding contact metal as described elsewhere herein. Mobile computing platform 1305 may be any portable device configured for each of electronic data display, electronic data processing, wireless electronic data transmission, or the like. For example, mobile computing platform 1305 may be any of a tablet, a smart phone, a laptop computer, etc., and may include a display screen (e.g., a capacitive, inductive, resistive, or optical touchscreen), a chip-level or package-level integrated system 1310, and a battery/power supply 1315. Although illustrated with respect to mobile computing platform 1305, in other examples, chip-level or package-level integrated system 1310 and a battery/power supply 1315 may be implemented in a desktop computing platform, an automotive computing platform, an internet of things platform, or the like. As discussed below, in some examples, the disclosed systems may include a sub-system 1360 such as a system on a chip (SOC) or an integrated system of multiple ICs, which is illustrated with respect to mobile computing platform 1305.

Whether disposed within integrated system 1310 illustrated in expanded view 1320 or as a stand-alone packaged device within data server machine 1306, sub-system 1360 may include memory circuitry and/or processor circuitry 1340 (e.g., RAM, a microprocessor, a multi-core microprocessor, graphics processor, etc.), a power management integrated circuit (PMIC) 1330, a controller 1335, and a radio frequency integrated circuit (RFIC) 1325 (e.g., including a wideband RF transmitter and/or receiver (TX/RX)). As shown, one or more IC dice, such as memory circuitry and/or processor circuitry 1340 may be assembled and implemented such that one or more have a spacer material between a source or drain structure and a corresponding contact metal as described herein. In some embodiments, RFIC 1325 includes a digital baseband and an analog front end module further comprising a power amplifier on a transmit path and a low noise amplifier on a receive path). Functionally, PMIC 1330 may perform battery power regulation, DC-to-DC conversion, etc., and so has an input coupled to battery/power supply 1315, and an output providing a current supply to other functional modules. As further illustrated in FIG. 13, in the exemplary embodiment, RFIC 1325 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 1340 may provide memory functionality for sub-system 1360, high level control, data processing and the like for sub-system 1360. In alternative implementations, each of the SOC modules may be integrated onto separate ICs coupled to a package substrate, interposer, or board.

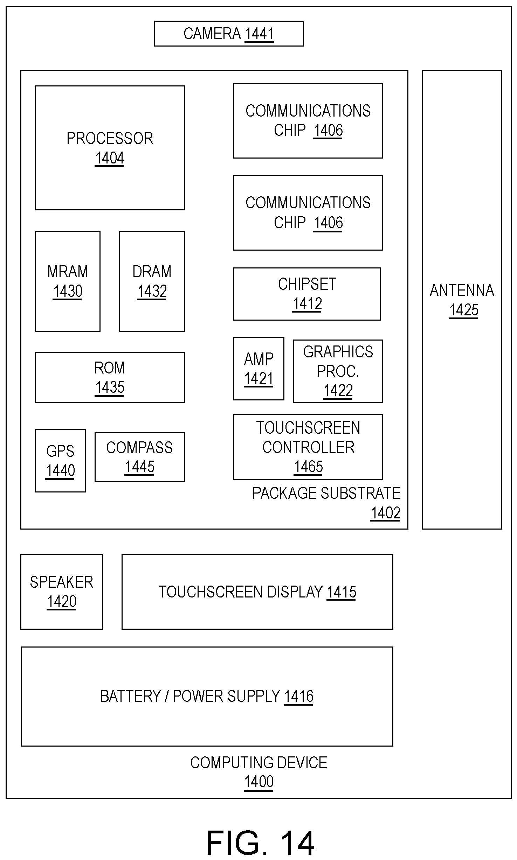

FIG. 14 is a functional block diagram of an electronic computing device 1400, in accordance with some embodiments. For example, device 1400 may, via any suitable component therein, implement a field effect transistor having a spacer material between a source or drain structure and a corresponding contact metal as discussed herein. For example, one or more IC dies of electronic computing device 1400 may deploy a GAA transistor having a spacer material between a source or drain structure and a corresponding contact metal. Device 1400 further includes a motherboard or package substrate 1402 hosting a number of components, such as, but not limited to, a processor 1404 (e.g., an applications processor). Processor 1404 may be physically and/or electrically coupled to package substrate 1402. In some examples, processor 1404 is within an IC assembly. In general, the term "processor" or "microprocessor" may refer to any device or portion of a device that processes electronic data from registers and/or memory to transform that electronic data into other electronic data that may be further stored in registers and/or memory.

In various examples, one or more communication chips 1406 may also be physically and/or electrically coupled to the package substrate 1402. In further implementations, communication chips 1406 may be part of processor 1404. Depending on its applications, computing device 1400 may include other components that may or may not be physically and electrically coupled to package substrate 1402. These other components include, but are not limited to, volatile memory (e.g., DRAM 1432), non-volatile memory (e.g., ROM 1435), flash memory (e.g., NAND or NOR), magnetic memory (MRAM 1430), a graphics processor 1422, a digital signal processor, a crypto processor, a chipset 1412, an antenna 1425, touchscreen display 1415, touchscreen controller 1465, battery/power supply 1416, audio codec, video codec, power amplifier 1421, global positioning system (GPS) device 1440, compass 1445, accelerometer, gyroscope, speaker 1420, camera 1441, and mass storage device (such as hard disk drive, solid-state drive (SSD), compact disk (CD), digital versatile disk (DVD), and so forth, or the like.

Communication chips 1406 may enable wireless communications for the transfer of data to and from the computing device 1400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1406 may implement any of a number of wireless standards or protocols, including, but not limited to, those described elsewhere herein. As discussed, computing device 1400 may include a plurality of communication chips 1406. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others. Battery/power supply 1416 may include any suitable power supply circuitry and, optionally, a battery source to provide power to components of electronic computing device 1400.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described but can be practiced with modification and alteration without departing from the scope of the appended claims. For example, the above embodiments may include specific combinations of features as further provided below.

The following pertains to exemplary embodiments.

In one or more first embodiments, an apparatus or transistor structure comprises one or more semiconductor structures over a substrate and extending between a source structure and a drain structure, at least one of the source structure or the drain structure epitaxial to the one or more semiconductor structures, a gate structure adjacent to one or more channel regions of the one or more semiconductor structures, a spacer material between the gate structure and the at least one of the source structure or the drain structure, and a backside contact metal extending through the substrate and in contact with the at least one of the source structure or the drain structure, such that a portion of the spacer material is in contact with and between a portion of the backside contact metal and a portion of the at least one of the source structure or the drain structure.

In one or more second embodiments, further to the first embodiments, the spacer material comprises a continuous monolithic material portion in contact with the gate structure, the portion of the backside contact metal, and the portion of the at least one of the source structure or the drain structure.

In one or more third embodiments, further to the first or second embodiments, the spacer material comprises a second continuous monolithic material portion in contact with a second gate structure, a second portion of the backside contact metal, and a second portion of the at least one of the source structure or the drain structure.

In one or more fourth embodiments, further to the first through third embodiments, the spacer material comprises a second continuous monolithic material portion in contact with the gate structure and a second portion of the at least one of the source structure or the drain structure, wherein the second continuous monolithic material portion is vertically aligned with the continuous monolithic material portion.

In one or more fifth embodiments, further to the first through fourth embodiments, the spacer material comprises silicon and one or more of oxygen, nitrogen, and carbon.

In one or more sixth embodiments, further to the first through fifth embodiments, the backside contact metal comprises one of titanium or tungsten.

In one or more seventh embodiments, further to the first through sixth embodiments, the backside contact metal is in contact with the source structure, the apparatus further comprising a frontside contact metal in contact with the drain structure.

In one or more eighth embodiments, further to the first through seventh embodiments, the one or more semiconductor structures comprises a plurality of vertically aligned nanoribbons or nanosheets.

In one or more ninth embodiments, a system comprises an integrated circuit (IC) die including a transistor structure according to any of the first through eighth embodiments, and a power supply, wireless device, or memory die coupled to the IC die.

In one or more tenth embodiments, a system comprises an IC die comprising a transistor, the transistor comprising a stack of nanoribbons over a substrate, and coupled to a source and a drain each epitaxial to the stack of nanoribbons, a gate structure on channel regions of the nanoribbons, a spacer material between the gate structure and each of the source and the drain, and a backside contact extending through the substrate and in contact with one of the source or the drain, such that a portion of the spacer material is in contact with and between a portion of the backside contact and a portion of the source or the drain, and a power supply, wireless device, or memory die coupled to the IC die

In one or more eleventh embodiments, further to the tenth embodiments, the spacer material comprises a continuous material portion in contact with the gate structure, the portion of the backside contact, and the portion of the source or the drain.

In one or more twelfth embodiments, further to the tenth or eleventh embodiments, the spacer material comprises a second continuous material portion in contact with a second gate structure, a second portion of the backside contact, and a second portion of the source or the drain.

In one or more thirteenth embodiments, further to the tenth through twelfth embodiments, the spacer material comprises a second continuous material portion in contact with the gate structure and a second portion of the source or the drain, such that the second continuous material portion is vertically aligned with the continuous material portion.

In one or more fourteenth embodiments, further to the tenth through thirteenth embodiments, the spacer material comprises silicon and one or more of oxygen, nitrogen, and carbon, and the backside contact comprises one of titanium or tungsten.

In one or more fifteenth embodiments, further to the tenth through fourteenth embodiments, the backside contact is in contact with the source, the transistor further comprising a frontside contact in contact with the drain.

In one or more sixteenth embodiments, a method comprises receiving a multilayer stack over a substrate, the multilayer stack comprising a plurality of semiconductor material layers interleaved with a plurality of sacrificial layers, forming a contact hole in the substrate adjacent to the multilayer stack and filling the contact hole with a sacrificial material, recess etching the plurality of sacrificial layers to form recesses adjacent the plurality of sacrificial layers, forming a spacer material within the recesses adjacent the plurality of sacrificial layers, wherein a portion of the spacer material is on the sacrificial material, and growing a source structure or a drain structure from the plurality of semiconductor material layers and over the sacrificial material.

In one or more seventeenth embodiments, further to the sixteenth embodiments, the method further comprises exposing the sacrificial material by removal of a portion of the substrate, and replacing the sacrificial material with a contact metal.

In one or more eighteenth embodiments, further to the sixteenth or seventeenth embodiments, a portion of the spacer material is in contact with and between a portion of the contact metal and a portion of the source structure or the drain structure.

In one or more nineteenth embodiments, further to the sixteenth through eighteenth embodiments, the contact metal comprises one of titanium or tungsten.

In one or more twentieth embodiments, further to the sixteenth through nineteenth embodiments, the method further comprises replacing the sacrificial layers with one or more gate structures coupled to channel regions of the semiconductor material layers.

In one or more twenty-first embodiments, further to the sixteenth through twentieth embodiments, the spacer material comprises silicon and one or more of oxygen, nitrogen, and carbon.

It will be recognized that the invention is not limited to the embodiments so described but can be practiced with modification and alteration without departing from the scope of the appended claims. For example, the above embodiments may include specific combination of features. However, the above embodiments are not limited in this regard, and, in various implementations, the above embodiments may include the undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
one or more semiconductor structures over a substrate and extending between a source structure and a drain structure, at least one of the source structure or the drain structure epitaxial to the one or more semiconductor structures;
a gate structure adjacent to one or more channel regions of the one or more semiconductor structures;
a spacer material between the gate structure and the at least one of the source structure or the drain structure; and
a backside contact metal extending through the substrate and in contact with the at least one of the source structure or the drain structure, wherein a portion of the spacer material is in contact with and between a portion of the backside contact metal and a portion of the at least one of the source structure or the drain structure.

2. The apparatus of claim 1, wherein the spacer material comprises a continuous monolithic material portion in contact with the gate structure, the portion of the backside contact metal, and the portion of the at least one of the source structure or the drain structure.

3. The apparatus of claim 2, wherein the spacer material comprises a second continuous monolithic material portion in contact with a second gate structure, a second portion of the backside contact metal, and a second portion of the at least one of the source structure or the drain structure.

4. The apparatus of claim 2, wherein the spacer material comprises a second continuous monolithic material portion in contact with the gate structure and a second portion of the at least one of the source structure or the drain structure, wherein the second continuous monolithic material portion is vertically aligned with the continuous monolithic material portion.

5. The apparatus of any of claims 1 to 4, wherein the spacer material comprises silicon and one or more of oxygen, nitrogen, and carbon.

6. The apparatus of any of claims 1 to 5, wherein the backside contact metal comprises one of titanium or tungsten.

7. The apparatus of any of claims 1 to 6, wherein the backside contact metal is in contact with the source structure, the apparatus further comprising a frontside contact metal in contact with the drain structure.

8. The apparatus of any of claims 1 to 7, wherein the one or more semiconductor structures comprises a plurality of vertically aligned nanoribbons or nanosheets.

9. The apparatus of any of claims 1 to 8, comprising:
an integrated circuit (IC) die comprising a transistor structure, the transistor structure comprising the one or more semiconductor structures, the substrate, the source structure, the drain structure, the gate structure, the spacer material, and the backside contact metal; and
a power supply coupled to the IC die.

10. A method, comprising:
receiving a multilayer stack over a substrate, the multilayer stack comprising a plurality of semiconductor material layers interleaved with a plurality of sacrificial layers;
forming a contact hole in the substrate adjacent to the multilayer stack and filling the contact hole with a sacrificial material;
recess etching the plurality of sacrificial layers to form recesses adjacent the plurality of sacrificial layers;
forming a spacer material within the recesses adjacent the plurality of sacrificial layers, wherein a portion of the spacer material is on the sacrificial material; and
growing a source structure or a drain structure from the plurality of semiconductor material layers and over the sacrificial material.

11. The method of claim 10, further comprising:
exposing the sacrificial material by removal of a portion of the substrate; and
replacing the sacrificial material with a contact metal.

12. The method of claim 11, wherein a portion of the spacer material is in contact with and between a portion of the contact metal and a portion of the source structure or the drain structure.

13. The method of claim 11 or 12, wherein the contact metal comprises one of titanium or tungsten.

14. The method of any of claims 10 to 13, further comprising:
replacing the sacrificial layers with one or more gate structures coupled to channel regions of the semiconductor material layers.

15. The method of any of claims 10 to 14, wherein the spacer material comprises silicon and one or more of oxygen, nitrogen, and carbon.
